# EUROPÄISCHE PATENTSCHRIFT

(11) **EP 2 737 542 B1**
(45) Veröffentlichungstag und Bekanntmachung des Hinweises auf die Patenterteilung: **01.04.2020**
(21) Anmeldenummer: 12778942.8
(22) Anmeldetag: 26.06.2012
(51) Int. Cl.: H01L 31/0224

(54) **HERSTELLUNGSVERFAHREN EINER SOLARZELLE**
METHOD FOR PRODUCING A SOLAR CELL
PROCÉDÉ DE FABRICATION D'UNE CELLULE SOLAIRE

(30) Priorität: 28.07.2011 DE 102011052256
(43) Veröffentlichungstag der Anmeldung: 04.06.2014
(73) Patentinhaber: Hanwha Q CELLS GmbH, 06766 Bitterfeld-Wolfen (DE)
(72) Erfinder: STEKOLNIKOV, Andrey, 04105 Leipzig (DE); SEGUIN, Robert, 12109 Berlin (DE); KÖNTOPP, Max, 10559 Berlin (DE); SCHERFF, Maximilian, 44369 Dortmund (DE); ENGELHART, Peter, 04157 Leipzig (DE); HEIMANN, Matthias, 01277 Dresden (DE); BARTEL, Til, 12103 Berlin (DE); TRÄGER, Markus, 04155 Leipzig (DE)
(74) Vertreter: adares Patent- und Rechtsanwälte Reininger & Partner GmbB
(86) Internationale Anmeldenummer: PCT/DE2012/100189
(87) Internationale Veröffentlichungsnummer: WO 2013/013666

(56) Entgegenhaltungen:
- EP-A2- 2 423 981
- CN-A- 101 447 532
- US-A1- 2010 275 965
- US-A1- 2010 275 993
- Mohamed M. Hilali ET AL: "Effect of glass frit chemistry on the physical and electrical properties of thick-film Ag contacts for silicon solar cells", Journal of Electronic Materials, vol. 35, no. 11, 1 November 2006 (2006-11-01), pages 2041-2047, XP055059859, ISSN: 0361-5235, DOI: 10.1007/s11664-006-0311-x

## Beschreibung

Die vorliegende Erfindung betrifft eine Solarzelle sowie ein Verfahren zur Herstellung derselben. Insbesondere betrifft die vorliegende Erfindung eine Solarzelle mit spezieller Punktkontaktstruktur für die Verschaltung von Solarzellen auf Metall-Paste wie beispielsweise Aluminium-Paste und ein Verfahren zu deren Herstellung.

Der überwiegende Anteil heutiger Silizium-Solarzellen weist eine gedruckte und gefeuerte Rückseitenmetallisierung von Aluminium-haltiger Paste und Silberhaltiger Paste auf. Die Silber-haltigen Pastenbereiche auf der Rückseite sind zur Verschaltung mehrerer Solarzellen durch konventionelles Löten mit verzinnten Kupferbändchen nötig. Es gibt dabei aber mehrere Probleme. Aus Kostengründen und auch zur Steigerung der Effizienz von Solarzellen ist es wünschenswert, die Silber-Pastenbereiche auf der Rückseite der Solarzelle zu vermeiden und eine ganzflächige Aluminium-Pastenmetallisierung auf der Rückseite anzustreben. Zur Steigerung der Effizienz von Solarzellen ist es zudem vorteilhaft, eine passivierende dielektrische Schicht zwischen Rückseitenmetallisierung und Silizium-Oberfläche einzufügen. Eine Herausforderung hierbei ist die Realisierung einer ausreichend hohen Adhäsion von der Metallschicht auf der dielektrischen Schicht. Bei Verwendung von Silber-Pastenbereichen (so genannte Busbar-Bereiche zum Löten) wird die Haftung realisiert, in dem die Silber-Paste die dielektrische Schicht durchdringt und dadurch eine ausreichend hohe Haftung mit dem Siliziumwafer herstellt.

Eine Solarzelle mit einem Halbleiterwafer, einer auf dem Halbleiterwafer angeordneten Passivierungsschicht und einer darauf angeordneten Metallschicht, wobei in der Passivierungsschicht eine Kontaktstruktur mit punktförmig ausgebildeten Elektroden angeordnet ist, ist beispielsweise in der US2010/275965A1, US2010/275993A1 oder CN101447532A beschrieben.

Aufgabe der vorliegenden Erfindung ist, eine Solarzelle mit einer ausreichend hohen Haftkraft zwischen Halbleiterwafer/dielektrischer Schicht/Metallschicht bei Solarzellen mit dielektrischer Passivierung für eine mögliche direkte Verschaltung der Metallschicht sowie ein Verfahren zu deren Herstellung bereitzustellen.

Erfindungsgemäß wird diese Aufgabe durch ein Solarzellen-Herstellungsverfahren nach Anspruch 1 gelöst.

Vorteilhafte Ausgestaltungen der vorliegenden Erfindung sind in den Unteransprüchen angegeben.

Die vorliegende Erfindung betrifft ein Solarzellen-Herstellungsverfahren gemäß Anspruch 1. Hergestellt wird in diesem Verfahren eine Solarzelle mit einem Halbleiterwafer, mindestens einer auf dem Halbleiterwafer angeordneten dielektrischen Schicht, einer auf der dielektrischen Schicht angeordneten Metallschicht und einer Kontaktstruktur, die in der dielektrischen Schicht angeordnet ist, sodass die Kontaktstruktur eine elektrische Verbindung zwischen der Metallschicht und dem Halbleiterwafer bereitstellt. Die Kontaktstruktur weist mindestens eine erste Struktur mit einer Mindestabmessung und mindestens eine zweite Struktur mit einer Maximalabmessung auf. Die Mindestabmessung und die Maximalabmessung sind entlang einer Oberfläche des Halbleiterwafers definiert. Bei der Mindestabmessung einer Struktur handelt es sich also um die kleinste Abmessung der Struktur entlang der Oberfläche des Halbleiterwafers, während es sich bei der Maximalabmessung der Struktur um die größte Abmessung der Struktur entlang der Oberfläche des Halbleiterwafers handelt. Definitionsgemäß weist eine kreisförmige Struktur eine Mindestabmessung und eine Maximalabmessung auf, welche identisch sind. Die Mindestabmessung der ersten Struktur ist erfindungsgemäß größer als die Maximalabmessung der zweiten Struktur.

Die vorliegende Erfindung schlägt eine Kontaktstruktur in der dielektrisch passivierten Schicht von Solarzellen vor, die eine hohe Haftkraft zwischen Halbleiterwafer/dielektrischer Schicht/Metallschicht bei Solarzellen mit dielektrischer Passivierung für eine mögliche direkte Verschaltung der Metallschicht bereitstellt. Hierbei kann der Einsatz von Silber in der Solarzelle vermieden und somit Kosten gespart werden. Die Effizienz der Solarzelle ist im Vergleich zu einer herkömmlichen Solarzelle höher.

Der Halbleiterwafer ist bevorzugt ein Siliziumwafer. Ein Beispiel für eine dielektrische Schicht ist eine Aluminiumoxid- oder Siliziumnitridschicht. Die Metallschicht ist beispielsweise eine Aluminiumschicht.

Die Kontaktstruktur stellt eine Kombination einer ersten Struktur und einer zweiten Struktur dar, die unterschiedliche Abmessungen aufweisen. Die Mindestabmessung der ersten Struktur ist größer als die Maximalabmessung der zweiten Struktur. Dadurch weisen die Metallschicht und der Halbleiterwafer - im Vergleich zueinander - größerflächige und kleinerflächige Verbindungspunkte auf, was zu einer Punktkontaktstruktur führt, deren größer- und kleinerflächig wirkende Haftung in der Solarzelle entsprechend den Abmessungen der Solarzelle und den Hafterfordernissen an bestimmten Stellen der Solarzelle bereit gestellt werden kann. Die Anordnung der zweiten Struktur mit kleinflächiger Haftung zwischen ersten Strukturen bietet beispielsweise eine zusätzliche Haftung im Vergleich zu einer Solarzelle ohne zweite Struktur, wenn diese entweder gar keine Haftung in diesem Bereich aufweist, d.h. wenn in diesem Bereich auch nicht die erste Struktur angeordnet ist, oder eine Materialersparnis im Vergleich zu einer Solarzelle ohne zweite Struktur auf, wenn die Solarzelle ohne zweite Struktur in diesem Bereich die erste Struktur aufweist. Solarzellen, die nur die zweite Struktur, aber nicht die erste Struktur aufweisen, weisen eine schlechtere Haftung zwischen Halbleiterwafer/dielektrischer Schicht/Metallschicht im Vergleich zu der erfindungsgemäßen Solarzelle auf. Durch die Kombination der ersten und zweiten Strukturen in der Solarzelle kann eine optimale Haftung erzielt werden.

In einer bevorzugten Ausführungsform des Solarzellen-Herstellungsverfahrens liegen die Mindestabmessung der ersten Struktur im Millimeterbereich und die Maximalabmessung der zweiten Struktur im Mikrometerbereich. Die Wahl der Mindestabmessung der ersten Struktur im Millimeterbereich und der Maximalabmessung der zweiten Struktur im Mikrometerbereich ermöglicht die Anordnung von unterschiedlich großen Strukturen in der dielektrischen Schicht und die Herstellung einer Solarzelle mit hohem Haftvermögen zwischen Halbleiterwafer/dielektrischer Schicht/Metallschicht. Neben der Bereitstellung von großflächigen Haftbereichen wird das Haftvermögen durch kleinflächige Haftbereiche zusätzlich gesteigert, ohne die dielektrische Schicht und deren Eigenschaften zu eliminieren.

Vorzugweise umfasst der Millimeterbereich 0,1 bis 10 mm, bevorzugter 1 bis 7 mm, noch bevorzugter 3 bis 5 mm. Der Mikrometerbereich umfasst bevorzugt 10 bis 70 µm, bevorzugter 20 bis 60 µm, noch bevorzugter 30 bis 55 µm. Die Kombination von Strukturen mit diesen Größenordnungen stellt eine Punktkontaktstruktur zur Verfügung, die eine gute Haftung zwischen Halbleiterwafer/dielektrischer Schicht/Metallschicht realisiert.

In einer bevorzugten Ausführungsform weist die Solarzelle als die erste Struktur ein Aluminium-Silizium-Eutektikum und / oder die zweite Struktur einen Silizium-Metallkontakt oder einen Laser induzierten Kontakt (LFC: Laser Fired Contact) auf. Das Aluminium-Silizium-Eutektikum stellt eine feste, stabile Struktur dar. Durch die stoffschlüssige Verbindung der Metallschicht, die in diesem Fall eine Aluminiumschicht ist, und des Halbleiterwafers, der in diesem Fall ein Siliziumwafer ist, ist das Haftvermögen zwischen Aluminiumschicht und Siliziumwafer verbessert. Die Laser-Induzierung eines Kontakts hat den Vorteil, ihn in kleinen Dimensionen problemlos herstellen zu können und lokal eine Verbindung zwischen dem Metall wie beispielsweise Aluminium und Wafer wie beispielsweise Siliziumwafer zu erzeugen und somit die Haftung zwischen Metallschicht und Wafer zu verbessern.

Vorzugsweise weist die erste Struktur eine streifenförmige Gestalt auf. In diesem Fall weichen die Mindest- und Maximalabmessungen der ersten Struktur sehr voneinander ab. Die streifenförmige Gestalt eignet sich zur Verschaltung mit einem Verbinder zur Verschaltung von Solarzellen wie einem Verschaltungsbändchen.

Die zweite Struktur weist vorzugsweise eine punktförmige Gestalt auf. Die Mindest- und Maximalabmessungen der zweiten Struktur können gleich oder verschieden sein. Wenn sie verschieden sind, sind sie aber vorzugsweise annähernd gleich, sodass die zweite Struktur eine punktförmige Gestalt aufweist.

Die erste Struktur bietet eine großflächige Anordnung eines Haftbereichs für die Metallschicht und Wafer, während die zweite Struktur einen kleinflächigen Haftbereich bietet, der die Haftwirkung der ersten Struktur unterstützt, sodass die Entfernung der dielektrischen Schicht zur Erzielung einer Haftung durch Anordnung einer Kontaktstruktur in einem geringen Maße erfolgt und die Eigenschaften der dielektrischen Schicht weitgehend erhalten bleiben. D.h., die Steigerung der Effizienz der Solarzelle durch die Anordnung der dielektrischen Schicht bleibt aufgrund der Entfernung der dielektrischen Schicht in geringem Ausmaß und dem Einfügen einer Kontaktstruktur in die dielektrische Schicht erhalten und zusätzlich wird eine stabile Solarzelle mit aneinanderhaftenden Schichtkomponenten bereitgestellt.

Die Wahl einer streifenförmigen Gestalt für die erste Struktur und einer punktförmigen Gestalt für die zweite Struktur realisiert eine Kontaktstruktur mit einer sehr guten Haftung zwischen Halbleiterwafer/dielektrischer Schicht/Metallschicht durch Aufweisen einer ersten Struktur mit großflächiger Haftung und einer zweiten Struktur mit im Vergleich zu der ersten Struktur kleinflächiger Haftung. Die Anordnung der zweiten Struktur mit kleinflächiger Haftung zwischen ersten Strukturen bietet eine zusätzliche Haftung oder eine Materialersparnis im Vergleich zu einer Solarzelle ohne zweite Struktur. Die Bereitstellung großflächiger und kleinflächiger Strukturen ermöglicht weiterhin die Anordnung von Haftungspunkten in Größen, die bedarfgerecht an die Solarzelle angepasst werden können.

In einer bevorzugten Ausführungsform ist auf einer dem Halbleiterwafer abgewandten Oberfläche der Metallschicht ein Verbinder in einem Bereich angeordnet, der sich mit der ersten Struktur in Draufsicht überlappt. Der Verbinder ist vorzugsweise ein Aluminiumbändchen. Der Verbinder eignet sich zur Verschaltung der Solarzelle mit weiteren Solarzellen.

Vorzugsweise weist die erste Struktur ein Aluminium-Silizium-Eutektikum auf, das mit einem Verbinder unmittelbar kontaktiert ist. In diesem Fall sind der Halbleiterwafer ein Siliziumwafer und die Metallschicht eine Aluminiumschicht. Der Verbinder ist vorzugsweise ein Aluminiumbändchen. Der Verbinder und das Aluminium-Silizium-Eutektikum können eine stoffschlüssige Verbindung eingehen. Beispielsweise wird durch Ultraschall-Kaltschweißen ein stoffschlüssiger Kontakt bei Raumtemperatur erzeugt. Durch die Fläche aus Aluminium und Aluminium-Silizium-Eutektikum kann die Effizienz der Solarzelle weiterhin gesteigert werden. Hierdurch wird eine bessere Passivierung der Rückseite der Solarzelle erreicht. Weiterhin werden die Herstellungskosten einer derartigen Solarzelle reduziert, wenn ein Verbinder aus Aluminium eingesetzt wird, weil die bisher üblichen Silber-Busbars eingespart werden.

Gegenstand der vorliegenden Erfindung ist ein Solarzellen-Herstellungsverfahren, umfassend die Verfahrensschritte: Bereitstellen eines Halbleiterwafers mit mindestens einer dielektrischen Schicht, Ausbilden einer Metallschicht auf der dielektrischen Schicht und einer Kontaktstruktur, die in der dielektrischen Schicht angeordnet ist, sodass die Kontaktstruktur eine elektrische Verbindung zwischen der Metallschicht und dem Halbleiterwafer bereitstellt, wobei mindestens eine erste Struktur mit einer Mindestabmessung und mindestens eine zweite Struktur mit einer Maximalabmessung als Kontaktstruktur ausgebildet werden, sodass die Mindestabmessung der ersten Struktur größer ist als die Maximalabmessung der zweiten Struktur.

Die mindestens eine erste und zweite Struktur können auf verschiedene Weisen hergestellt werden, die nachstehend beschrieben sind. Die erste und zweite Struktur können durch den gleichen oder einen verschiedenen Verfahrensschritt hergestellt werden. Die Bildung der ersten und zweiten Struktur kann unabhängig voneinander durchgeführt werden. Die Einstellung der Mindestabmessung der ersten Struktur und der Maximalabmessung der zweiten Struktur ist verfahrensabhängig.

Das Ausbilden der Metallschicht und der Kontaktstruktur umfasst folgende Verfahrensschritte: Aufbringen mindestens einer zu der dielektrischen Schicht inerten Metall-Paste und mindestens einer zu der dielektrischen Schicht reaktiven Metall-Paste auf die dielektrische Schicht, sodass die zu der dielektrischen Schicht reaktive Metall-Paste mindestens einen ersten Bereich und/oder mindestens einen zweiten Bereich in der zu der dielektrischen Schicht inerten Metall-Paste bildet; und Feuern, sodass die zu der dielektrischen Schicht reaktive, den ersten und/oder zweiten Bereich bildende Metall-Paste die dielektrische Schicht durchdringt und die erste Struktur und/oder die zweite Struktur ausbildet. Das Aufbringen der zu der dielektrischen Schicht inerten und reaktiven Metall-Paste auf die dielektrische Schicht kann mittels Siebdruck realisiert werden. Die Einstellung der Mindestabmessung der ersten Struktur und der Maximalabmessung der zweiten Struktur erfolgt durch die Größe der Löcher des Siebes. Nach dem Feuern bildet die zu der dielektrischen Schicht inerte Metall-Paste die Metallschicht auf der dielektrischen Schicht, und die zu der dielektrischen Schicht reaktive Metall-Paste durchdringt die dielektrische Schicht und bildet die erste und/oder zweite Struktur aus. Die zu der dielektrischen Schicht inerte Metall-Paste ist vorzugsweise eine Metall-Paste wie eine Aluminium-Paste, die Metall, vorzugsweise in Pulverform, und optional mindestens einen zu der dielektrischen Schicht inerten Zusatzstoff wie beispielsweise ein Bindemittel, Lösungsmittel oder Sinterhilfsmittel enthält. Die zu der dielektrischen Schicht reaktive Paste ist bevorzugt eine Metall-Paste, die Metall wie beispielsweise ein Metallpulver, mindestens einen zu der dielektrischen Schicht reaktiven Zusatzstoff wie beispielsweise ein Ätzmittel und optional mindestens einen zu der dielektrischen Schicht inerten Zusatzstoff wie beispielsweise ein Bindemittel, Lösungsmittel oder Sinterhilfsmittel enthält. Beispielsweise ist die zu der dielektrischen Schicht reaktive Paste eine Aluminium-Paste, die als Ätzmittel Glasfritte enthält.

Bei einer weiteren bevorzugten Ausführungsform umfasst das Ausbilden der Metallschicht und der Kontaktstruktur folgende Verfahrensschritte: Bilden von mindestens einem ersten, zur Erzeugung der ersten Struktur geeigneten Loch und/oder mindestens einem zweiten, zur Erzeugung der zweiten Struktur geeigneten Loch in der dielektrischen Schicht; Auffüllen des mindestens einen ersten Lochs und/oder mindestens einen zweiten Lochs und Beschichten der dielektrischen Schicht mit einer Metall-Paste; und Feuern. In dieser Verfahrensvariante wird die dielektrische Schicht durchbrochen, und die durch den Durchbruch erzeugten Löcher werden mit Metall-Paste aufgefüllt. Als Metall-Paste wird vorzugsweise eine Aluminium-Paste verwendet. Die Metall-Paste ist zu der dielektrischen Schicht inert. Die Einstellung der Mindestabmessung der ersten Struktur und der Maximalabmessung der zweiten Struktur erfolgt durch die Einstellung des verwendeten Werkzeugs bei der Durchbrechung der dielektrischen Schicht. An Stellen, an denen das mindestens eine erste und/oder zweite Loch in der dielektrischen Schicht ist, ist der Halbeleiterwafer frei gelegt. Die Aluminium-Paste kann beim Feuern mit einem Siliziumwafer ein Aluminium-Silizium-Eutektikum ausbilden, das eine sehr feste Haftstruktur zwischen Metall, dielektrischer Schicht und Siliziumwafer darstellt.

Vorzugsweise werden das mindestens eine erste Loch und/oder das mindestens eine zweite Loch mittels Laserablation gebildet. Die Laserablation erlaubt eine Durchbrechung der dielektrischen Schicht, ohne dass die dielektrische Schicht Risse bekommt oder an Stellen, an denen sie intakt bleiben soll, bricht. Die Laserablation ermöglicht eine punktgenaue Erzeugung von Löchern in der dielektrischen Schicht in der gewünschten Größe. Alternativ ist es möglich, das Loch auf mechanische Weise zu erzeugen. Weiterhin alternativ ist es möglich, das Loch nasschemisch herzustellen.

In einer bevorzugten Ausführungsform wird die zweite Struktur in Form von LFC (laser fired contacts bzw. lasergefeuerten Kontakten) erzeugt. Hierbei wird lokal eine Verbindung zwischen Halbleiterwafer und Metall erzeugt. Wenn der Halbleiterwafer ein Siliziumwafer ist und die Metallschicht eine Aluminiumschicht ist, dann wird lokal ein Aluminium-Silizium-Eutektikum erzeugt.

Die erste Struktur und die zweite Struktur können somit durch unterschiedliche Verfahrensschritte erzeugt werden. Beispielsweise kann die erste Struktur durch das vorstehend beschriebene Aufbringen einer zu der dielektrischen Schicht reaktiven Metall-Paste und anschließendem Feuern und die zweite Struktur in Form von LFC erzeugt werden. Alternativ kann die erste Struktur durch das vorstehend beschriebene Bilden eines Lochs in der dielektrischen Schicht und Füllen des Lochs mit einer zu der dielektrischen Schicht inerten Metall-Paste und anschließendem Feuern und die zweite Struktur in Form von LFC erzeugt werden. Weiterhin alternativ kann die erste Struktur durch das vorstehend beschriebene Aufbringen einer zu der dielektrischen Schicht reaktiven Metall-Paste und die zweite Struktur durch das vorstehend beschriebene Bilden eines Lochs in der dielektrischen Schicht und Füllen des Lochs mit einer zu der dielektrischen Schicht inerten Metall-Paste und anschließendem Feuern erzeugt werden. Weiterhin alternativ kann die erste Struktur durch das vorstehend beschriebene Bilden eines Lochs in der dielektrischen Schicht und Füllen des Lochs mit einer zu der dielektrischen Schicht inerten Metall-Paste und die zweite Struktur durch das vorstehend beschriebene Aufbringen einer zu der dielektrischen Schicht reaktiven Metall-Paste und anschließendem Feuern erzeugt werden.

Weiterhin können die erste Struktur und die zweite Struktur durch einen gemeinsamen Verfahrensschritt erzeugt werden. Beispielsweise können die erste Struktur und die zweite Struktur durch das vorstehend beschriebene Aufbringen einer zu der dielektrischen Schicht reaktiven Metall-Paste und anschließendem Feuern erzeugt werden. Alternativ können die erste Struktur und die zweite Struktur durch das vorstehend beschriebene Bilden von Löchern in der dielektrischen Schicht und Füllen der Löcher mit einer zu der dielektrischen Schicht inerten Metall-Paste und anschließendem Feuern erzeugt werden.

In einer bevorzugten Ausführungsform des Herstellungsverfahrens wird mindestens ein Verbinder auf einer dem Halbleiterwafer abgewandten Oberfläche der Metallschicht in mindestens einem Bereich aufgebracht, der sich mit der ersten Struktur in Draufsicht überlappt. Der Verbinder wird beispielsweise mittels Bonden oder Löten aufgebracht und ist vorzugsweise ein Aluminiumbändchen, das sich zur Verschaltung mit weiteren Solarzellen eignet.

Bevorzugt weist das Herstellungsverfahren den Schritt Freilegen eines Aluminium-Silizium-Eutektikums in mindestens einer ersten Struktur und Ultraschall-Kaltverschweißen des Aluminium-Silizium-Eutektikums der ersten Struktur mit jeweils einem Verbinder auf. In diesem Fall sind der Halbleiterwafer ein Siliziumwafer und die Metallschicht eine Aluminiumschicht. Das Freilegen kann mittels Laserablation erfolgen. Alternativ kann das Freilegen auch durch mechanisches Durchbrechen der Metallschicht erfolgen. Mittels Ultraschall-Kaltverschweißen wird das Aluminium-Silizium-Eutektikum mit dem Verbinder wie beispielsweise einem Aluminium-Band stoffschlüssig kontaktiert. Die mindestens eine erste und mindestens eine zweite Struktur einer derartigen Solarzelle kann durch irgendeinen der vorstehend beschriebenen Verfahrenschritte zur Ausbildung der ersten und/oder zweiten Struktur hergestellt werden.

Die vorliegende Erfindung wird nun unter Bezugnahme auf Figuren detaillierter erläutert, ohne die Erfindung darauf einzuschränken.

Die Figuren zeigen:
Fig. 1 eine Querschnittsansicht einer erfindungsgemäßen Solarzelle;
Fig. 2 eine Querschnittsansicht der Solarzelle gemäß Fig. 1 vor dem Feuerschritt;
Fig. 3 eine Teilquerschnittsansicht der Solarzelle gemäß Fig. 1;
Fig. 4 eine Querschnittsansicht einer weiteren erfindungsgemäßen Solarzelle;
Fig. 5 ein Herstellungsverfahren für die Solarzelle gemäß Fig. 1;
Fig. 6 ein alternatives Herstellungsverfahren für die Solarzelle gemäß Fig. 1;
Fig. 7 ein weiteres alternatives Herstellungsverfahren für eine Solarzelle gemäß Figur 1;
Fig. 8 ein weiteres alternatives Herstellungsverfahren für eine Solarzelle gemäß Figur 1; und
Fig. 9 ein Herstellungsverfahren für eine Solarzelle gemäß Fig. 4.

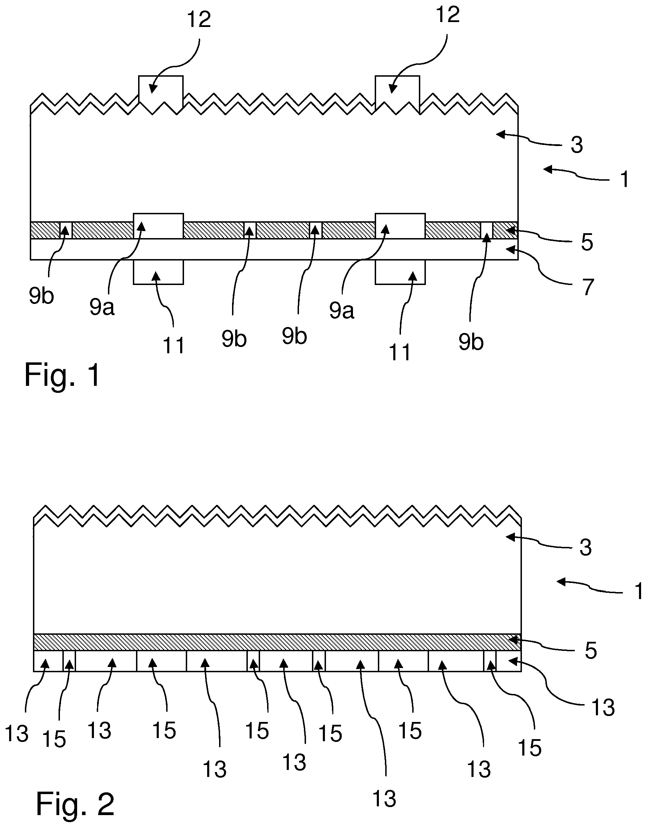

Fig. 1 zeigt eine Querschnittsansicht einer erfindungsgemäßen Solarzelle 1. Die Solarzelle 1 umfasst einen Halbleiterwafer 3 wie zum Beispiel einen Siliziumwafer. Auf der Rückseite des Halbleiterwafers 3 ist eine dielektrische Schicht 5 angeordnet. Weiterhin weist die Solarzelle 1 zwei erste Strukturen 9a auf. Die ersten Strukturen 9a sind in der dielektrischen Schicht 5 angeordnet und ragen teilweise in den Halbleiterwafer 3 hinein. Weiterhin sind in der dielektrischen Schicht 5 zweite Strukturen 9b (von denen vier sichtbar sind) angeordnet, deren Maximalabmessung kleiner sind als die Minimalabmessung der ersten Struktur 9a. Die dielektrische Schicht 5, die ersten Strukturen 9a und die zweiten Strukturen 9b sind von einer Metallschicht 7 wie beispielsweise einer Aluminiumschicht bedeckt. Auf der Vorderseite des Halbleiterwafers 3 sind zwei Verschaltungsbändchen 12 beispielsweise aus Aluminium angeordnet. Auf der Rückseite der Solarzelle 1 sind als Verbinder zwei Verschaltungsbändchen 11, beispielsweise Aluminiumbändchen, auf der Metallschicht 7 in Bereichen angeordnet, die in Draufsicht mit den ersten Strukturen 9a überlappen.

Fig. 2 zeigt eine Querschnittsansicht der Solarzelle 1 gemäß Fig. 1 vor dem Feuerschritt. Die Solarzelle 1 umfasst den Halbleiterwafer 3 und die darauf angeordnete dielektrische Schicht 5. Auf der dielektrischen Schicht 5 ist eine Metall-Pastenschicht angeordnet. Die Metall-Pastenschicht umfasst eine zu der dielektrischen Schicht inerte Metall-Paste 13 und eine zu der dielektrischen Schicht reaktive Metall-Paste 15. Die Metall-Pasten 13 und 15 werden mittels Siebdruckverfahren aufgetragen. Beim Feuern der in Fig. 2 dargestellten Solarzelle 1 durchdringt die zu der dielektrischen Schicht 5 reaktive Metall-Paste 15 die dielektrische Schicht 5 und bildet die in Fig. 1 dargestellten Strukturen 9a und 9b aus, und die zu der dielektrischen Schicht 5 inerte Metall-Paste bildet die Metallschicht 7.

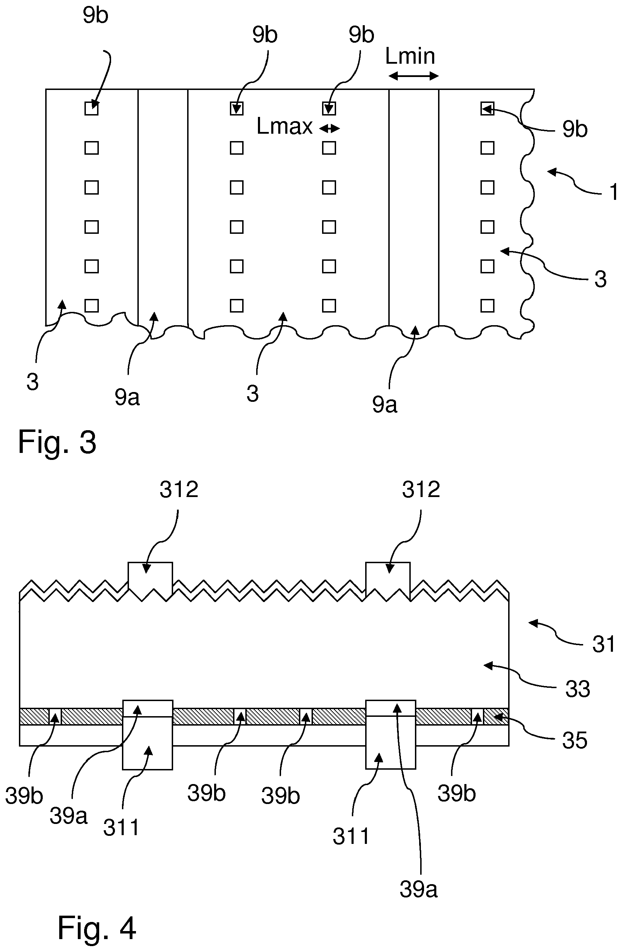

Fig. 3 zeigt eine Teilquerschnittsansicht der Solarzelle gemäß Fig. 1. Gezeigt ist ein Querschnitt durch die dielektrische Schicht 5 der Solarzelle 1 parallel zu der Schichtebene. In der dielektrischen Schicht 5 sind die ersten und zweiten Strukturen 9a (von denen zwei gezeigt sind) und 9b (von denen vierundzwanzig gezeigt sind) angeordnet. Die erste Struktur 9a weist jeweils eine streifenförmige Gestalt auf, während die zweite Struktur 9b jeweils eine punktförmige Gestalt aufweist. Die Minimalabmessung Lmin der ersten Struktur 9a ist größer als die Maximalstruktur Lmax der zweiten Struktur 9b. Durch die in Fig. 3 gezeigte Anordnung der ersten und zweiten Strukturen 9a und 9b wird eine gute Haftfähigkeit des Solarzellenaufbaus gewährleistet.

Fig. 4 zeigt eine Querschnittsansicht einer weiteren erfindungsgemäßen Solarzelle 31. Die Solarzelle 31 umfasst einen Halbleiterwafer 33. Auf der Rückseite des Halbleiterwafers 33 ist eine dielektrische Schicht 35 angeordnet. Auf der dielektrischen Schicht 35 ist eine Metallschicht 37 wie zum Beispiel eine Aluminiumschicht angeordnet. Weiterhin weist die Solarzelle 31 zwei erste Strukturen 39a auf. Die ersten Strukturen 39a sind in der dielektrischen Schicht 35 angeordnet und ragen teilweise in den Halbleiterwafer 33 hinein. Weiterhin sind in der dielektrischen Schicht 35 zweite Strukturen 39b (von denen vier sichtbar sind) angeordnet, deren Maximalabmessung kleiner sind als die Minimalabmessung der ersten Struktur 39a. Auf der dem Halbleiterwafer 33 abgewandten Oberfläche der Metallschicht 37 ist ein Verbinder 311 wie beispielsweise ein Aluminiumbändchen als Verschaltungsbändchen (von dem zwei gezeigt sind) jeweils in einem Bereich angeordnet, der sich mit der ersten Struktur 39a in Draufsicht überlappt. Diese Überlappung kann dadurch erreicht werden, dass die Metallschicht 37 beispielsweise durch mechanische Einwirkung durchbrochen wird, sodass die Struktur 39a freigelegt wird und der Verbinder 311 mit der ersten Struktur 39a mittels Ultraschall-Kaltverschweißen kontaktiert wird. Auf der Vorderseite des Halbleiterwafers 33 sind zwei Verschaltungsbändchen 312 wie zum Beispiel Aluminiumbändchen angeordnet.

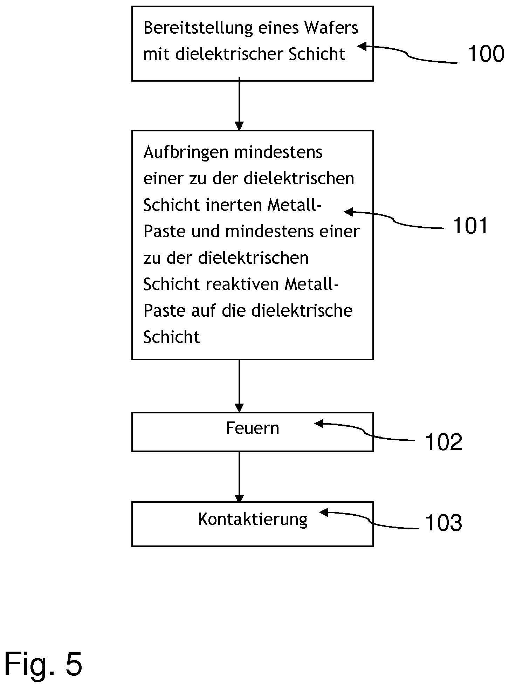

Bei dem in Fig. 5 gezeigten Verfahren handelt es sich um ein Beispiel eines Verfahrens zur Herstellung der in Fig. 1 gezeigten Solarzelle 1: Das Verfahren umfasst die folgenden Schritte: Bereitstellung eines Wafers mit dielektrischer Schicht 100; Aufbringen mindestens einer zu der dielektrischen Schicht inerten Metall-Paste und mindestens einer zu der dielektrischen Schicht reaktiven Metall-Paste auf die dielektrische Schicht 101; Feuern 102; und Kontaktierung 103. Der Schritt 100 umfasst beispielsweise die Bereitstellung des Halbleiterwafers 3 mit einer dielektrischen Schicht 5 in einer Vorrichtung, die zur Beschichtung der dielektrischen Schicht 5 geeignet ist. Der Schritt 101 kann mittels Siebdruckverfahrens erfolgen. Das Siebdruckverfahren ermöglicht die Aufbringung chemisch unterschiedlicher Metall-Pasten in definierten Bereichen als eine Schicht. Die zu der dielektrischen Schicht 5 reaktive Metall-Paste ist in der zu der dielektrischen Schicht inerten Metall-Paste derart angeordnet, wie es in Fig. 2 gezeigt ist, d.h. mittels des Siebdrucks wird eine Schicht aus zu der dielektrischen Schicht 5 inerter Metall-Paste 13 und zu der dielektrischen Schicht 5 reaktiver Metall-Paste 15 gebildet. Der Schritt 102 bewirkt, dass die zu der dielektrischen Schicht 5 reaktive Metall-Paste 15 durch die dielektrische 5 Schicht dringt, die ersten Strukturen 9a und die zweiten Strukturen 9b ausbildet und somit die Haftung zwischen dem in Fig. 1 dargestellten Halbleiterwafer 3, der dielektrischen Schicht 5 und der Metallschicht 7 realisiert wird. Durch den Schritt 103 wird der Verbinder 11 mit der Metallschicht 7 kontaktiert und der Halbleiterwafer 3 mit dem Verschaltungsbändchen 12 kontaktiert.

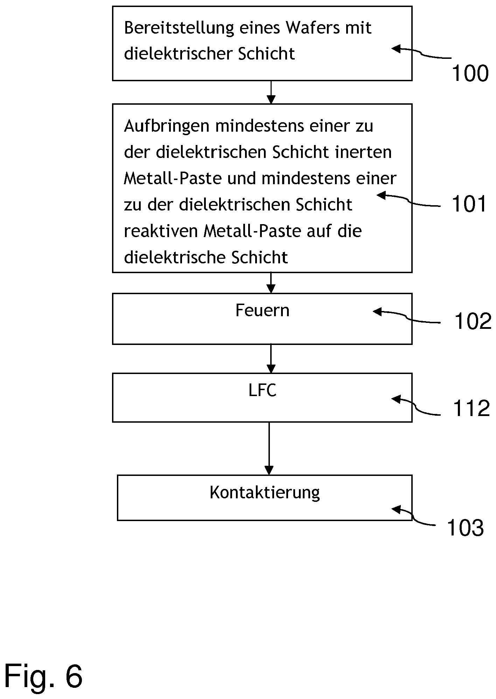

Bei dem in Fig. 6 gezeigten Verfahren handelt es sich um ein weiteres Beispiel eines Verfahrens zur Herstellung der in Fig. 1 gezeigten Solarzelle 1: Das Verfahren umfasst die folgenden Schritte: Bereitstellung eines Wafers mit dielektrischer Schicht 100; Aufbringen mindestens einer zu der dielektrischen Schicht inerten Metall-Paste und mindestens einer zu der dielektrischen Schicht reaktiven Metall-Paste auf die dielektrische Schicht 101; Feuern 102; Bilden von lasergefeuerten Kontakten (LFC) 112; Kontaktierung 103. Der Schritt 100 umfasst die Bereitstellung des Halbleiterwafers 3 mit einer dielektrischen Schicht 5 in einer Vorrichtung, die zur Beschichtung der dielektrischen Schicht 5 geeignet ist. Der Schritt 101 umfasst das Aufbringen der zu der dielektrischen Schicht 5 reaktiven Metall-Paste 15 und der zu der dielektrischen Schicht 5 inerten Metall-Paste 13, d.h. mittels des Siebdrucks wird eine Schicht aus zu der dielektrischen Schicht 5 inerten Metall-Paste 13 und zu der dielektrischen 5 Schicht reaktiven, zur Ausbildung der ersten Struktur 9a geeigneten Metall-Paste 15 gebildet. Der Schritt 102 bewirkt, dass sich die zu der dielektrischen Schicht 5 reaktive Metall-Paste 15 durch die dielektrische Schicht 5 dringt und die erste Struktur 9a ausbildet und die zu der dielektrischen Schicht 5 inerte Metall-Paste die Metallschicht 7 ausbildet. Durch den Schritt 112 wird die zweite Struktur 9b ausgebildet. Durch den Schritt 103 wird der Verbinder 11 mit der Metallschicht 7 kontaktiert und der Halbleiterwafer 3 mit dem Verschaltungsbändchen 12 kontaktiert.

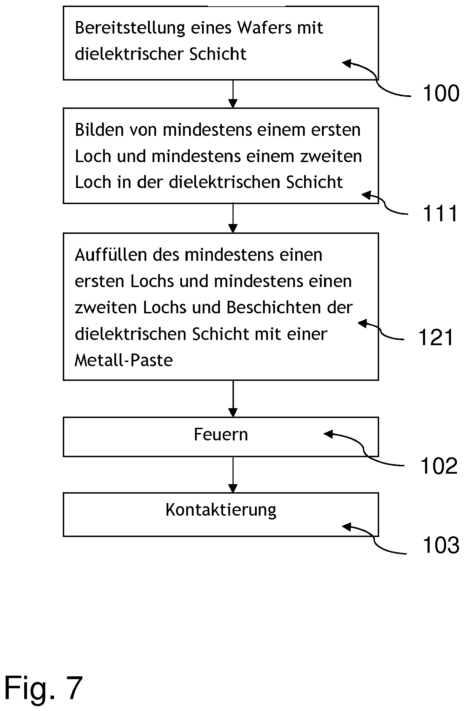

Bei dem in Fig. 7 gezeigten Verfahren handelt es sich um noch ein weiteres Beispiel eines Verfahrens zur Herstellung der in Fig. 1 gezeigten Solarzelle 1: Das Verfahren umfasst die folgenden Schritte: Bereitstellung eines Wafers mit dielektrischer Schicht 100; Bilden von mindestens einem ersten Loch und/oder mindestens einem zweiten Loch in der dielektrischen Schicht 111; Auffüllen des mindestens einen ersten Lochs und/oder mindestens einen zweiten Lochs und Beschichten der dielektrischen Schicht mit einer Metall-Paste 121; Feuern 102; Kontaktierung 103. Der Schritt 100 umfasst beispielsweise die Bereitstellung des Halbleiterwafers 3 mit einer dielektrischen Schicht 5 in einer Vorrichtung, die zur Beschichtung der dielektrischen Schicht 5 geeignet ist. Der Schritt 111 kann mittels Laserablation erfolgen. Mittels Laserablation werden in der dielektrischen Schicht Löcher gebildet, die zur Bildung der Strukturen 9a und 9b geeignet sind. Die Löcher werden derart ausgebildet, dass der Halbleiterwafer 3 im Lochbereich freiliegt. Der Schritt 121 umfasst das Aufbringen von zu der dielektrischen Schicht 5 inerter Metall-Paste wie beispielsweise einer Aluminium-Paste. Die Metall-Paste füllt die in der dielektrischen Schicht 5 erzeugten Löcher und bildet eine auf der dielektrischen Schicht 5 angeordnete Metall-Pastenschicht aus. Der Schritt 102 bewirkt, dass die Metallschicht 7 auf der dielektrischen Schicht 5 ausgebildet wird und dass sich ein Aluminium-Silizium-Eutektikum in Bereichen bildet, in denen die Aluminium-Paste als Metall-Paste auf dem Halbleiterwafer 3 angeordnet ist. Die Haftung wird somit zwischen dem in Fig. 1 dargestellten Halbleiterwafer 3, der dielektrischen Schicht 5 und der Metallschicht 7 realisiert. Durch den Schritt 103 wird der Verbinder 11 mit der Metallschicht 7 kontaktiert und der Halbleiterwafer 3 mit dem Verschaltungsbändchen 12 kontaktiert.

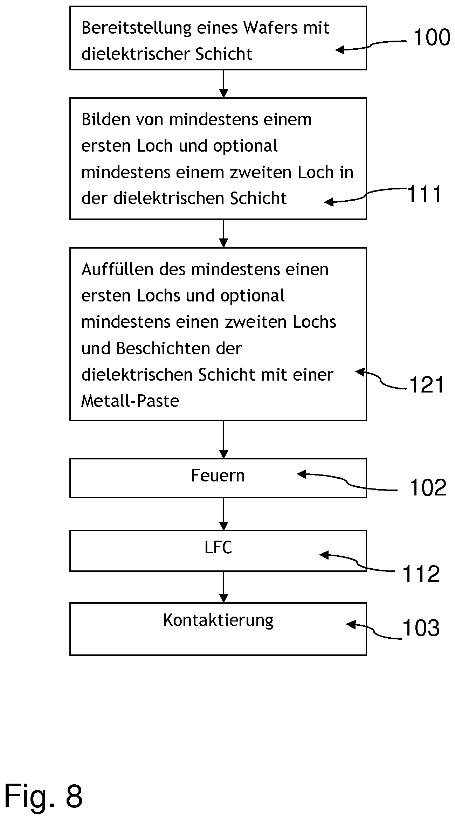

Bei dem in Fig. 8 gezeigten Verfahren handelt es sich um ein weiteres Beispiel eines Verfahrens zur Herstellung der in Fig. 1 gezeigten Solarzelle 1. Das Verfahren umfasst die folgenden Schritte: Bereitstellung eines Wafers mit dielektrischer Schicht 100; Bilden von mindestens einem ersten Loch und optional mindestens einem zweiten Loch in der dielektrischen Schicht 111; Auffüllen des mindestens einen ersten Lochs und optional mindestens einen zweiten Lochs und Beschichten der dielektrischen Schicht mit einer Metall-Paste 121; Feuern 102; Bilden von lasergefeuerten Kontakten (LFC) 112; und Kontaktierung 103. Der Schritt 100 umfasst beispielsweise die Bereitstellung des Halbleiterwafers 3 mit einer dielektrischen Schicht 5 in einer Vorrichtung, die zur Beschichtung der dielektrischen Schicht 5 geeignet ist. Der Schritt 111 kann mittels Laserablation erfolgen. Mittels Laserablation werden in der dielektrischen Schicht Löcher gebildet, die zur Bildung der ersten Strukturen 9a und optional der zweiten Strukturen 9b geeignet sind. Die Löcher werden derart ausgebildet, dass der Halbleiterwafer 3 im Lochbereich freiliegt. Der Schritt 121 umfasst das Aufbringen von zu der dielektrischen Schicht 5 inerter Metall-Paste. Die Metall-Paste füllt die in der dielektrischen Schicht 5 erzeugten Löcher und bildet eine auf der dielektrischen Schicht 5 angeordnete Metall-Pastenschicht aus. Der Schritt 102 bewirkt, dass die Metallschicht 7 auf der dielektrischen Schicht 5 und die Struktur 9a in der dielektrischen Schicht 5 ausgebildet wird und dass sich ein Aluminium-Silizium-Eutektikum in Bereichen bildet, in denen die Aluminium-Paste als Metall-Paste auf dem Halbleiterwafer 3 angeordnet ist. Mittels Schritt 112 wird die zweite Struktur 9b gebildet. Die Kombination der Schritte 111, 121 und 112, führt zu der Bildung einer guten Haftung zwischen Halbleiterwafer 3, dielektrischer Schicht 5 und Metallschicht 7. Der Schritt 103 umfasst die Kontaktierung des Verbinders 11 mit der Metallschicht 7 und die Kontaktierung des Halbleiterwafers 3 mit dem Verschaltungsbändchen 12.

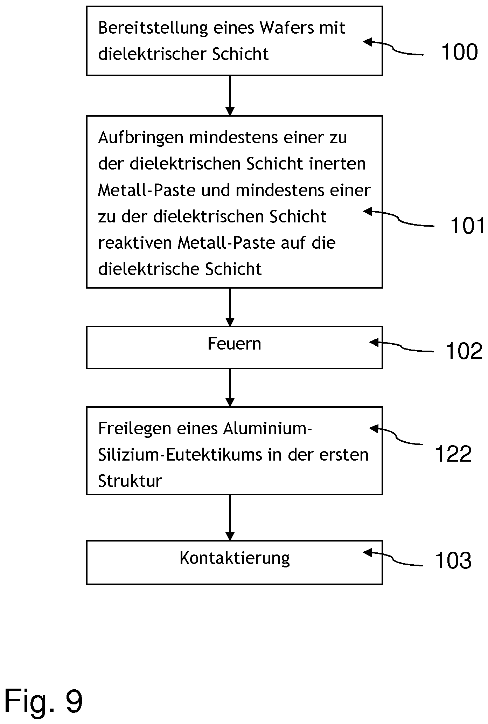

Bei dem in Fig. 9 gezeigten Verfahren handelt es sich um ein Beispiel eines Verfahrens zur Herstellung der in Fig. 4 gezeigten Solarzelle 31. Das Verfahren umfasst die folgenden Schritte: Bereitstellung eines Wafers mit dielektrischer Schicht 100; Aufbringen mindestens einer zu der dielektrischen Schicht inerten Metall-Paste und mindestens einer zu der dielektrischen Schicht reaktiven Metall-Paste auf die dielektrische Schicht 101; Feuern 102; Freilegen eines Aluminium-Silizium-Eutektikums in der ersten Struktur 122; und Kontaktierung 103. Der Schritt 100 umfasst beispielsweise die Bereitstellung des Halbleiterwafers 33 mit einer dielektrischen Schicht 35 in einer Vorrichtung, die zur Beschichtung der dielektrischen Schicht 35 geeignet ist. Der Schritt 101 kann mittels Siebdruckverfahrens erfolgen. Als Metall-Pasten werden Aluminium-Pasten eingesetzt. Die zu der dielektrischen Schicht 35 reaktive Metall-Paste ist in der zu der dielektrischen Schicht inerten Metall-Paste derart angeordnet, wie es in Fig. 2 gezeigt ist, d.h. mittels des Siebdrucks wird eine Schicht aus zu der dielektrischen Schicht 35 inerter Metall-Paste und zu der dielektrischen Schicht 35 reaktiver Metall-Paste gebildet. Der Schritt 102 bewirkt, dass die zu der dielektrischen Schicht 35 reaktive Metall-Paste durch die dielektrische 35 Schicht dringt, die ersten Strukturen 39a und die zweiten Strukturen 39b ausbildet und somit die Haftung zwischen dem in Fig. 4 dargestellten Halbleiterwafer 33, der dielektrischen Schicht 35 und der Metallschicht 37 realisiert wird und sich ein Aluminium-Silizium-Eutektikum an der Grenzfläche zwischen Halbleiterwafer 33 und Metallschicht 37 ausbildet. Durch Schritt 122 wird das beim Feuern gebildete Aluminium-Silizium-Eutektikum der ersten Struktur 39a mittels Laserablation freigelegt. Durch den Schritt 103 wird der Verbinder 311 mit dem Aluminium-Silizium-Eutektikum kontaktiert und der Halbleiterwafer 33 mit dem Verschaltungsbändchen 312 kontaktiert.

Das in Fig. 9 gezeigte Verfahren entspricht dem in Fig. 5 gezeigten Verfahren, wobei der Schritt 122, nämlich die Freilegung eines Aluminium-Silizium-Eutektikums, vor Schritt 103 ausgeführt wird. Wenn bei den in Figuren 6 bis 8 gezeigten Verfahren Schritt 122 vor Schritt 102 ausgeführt wird, sind die in diesen Figuren gezeigten Verfahren zur Herstellung der in Fig. 4 gezeigten Solarzelle 31 geeignet.

### Bezugszeichenliste:

- 1: Solarzelle
- 3: Halbleiterwafer
- 5: dielektrische Schicht
- 7: Metallschicht
- 9a: erste Struktur
- 9b: zweite Struktur
- 11: Verbinder
- 12: Verschaltungsbändchen
- 13: zu der dielektrischen Schicht inerte Metall-Paste
- 15: zu der dielektrischen Schicht reaktive Metall-Paste
- 31: Solarzelle
- 33: Halbleiterwafer
- 35: dielektrische Schicht
- 37: Metallschicht
- 39a: erste Struktur
- 39b: zweite Struktur
- 100: Bereitstellung eines Wafers mit dielektrischer Schicht
- 101: Aufbringen mindestens einer zu der dielektrischen Schicht inerten Metall-Paste und mindestens einer zu der dielektrischen Schicht reaktiven Metall-Paste auf die dielektrischen Schicht
- 102: Feuern
- 103: Kontaktierung
- 111: Bilden von mindestens einem ersten Loch und/oder mindestens einem zweiten Loch in der dielektrischen Schicht
- 112: Bilden von lasergefeuerten Kontakten
- 121: Auffüllen des mindestens einen ersten Lochs und/oder mindestens einen zweiten Lochs und Beschichten der dielektrischen Schicht mit einer Metall-Paste
- 122: Freilegen eines Aluminium-Silizium-Eutektikums in der ersten Struktur
- 311: Verbinder
- 312: Verschaltungsbändchen
- Lₘᵢₙ: Mindestlänge
- Lₘₐₓ: Maximallänge

## Patentansprüche

1. Solarzellen-Herstellungsverfahren, umfassend die Verfahrensschritte:
- Bereitstellen eines Halbleiterwafers (3, 31) mit mindestens einer dielektrischen Schicht (5, 35),
- Ausbilden einer Metallschicht (7, 37) auf der dielektrischen Schicht (5, 35) und einer Kontaktstruktur, die in der dielektrischen Schicht (5, 35) angeordnet ist, sodass die Kontaktstruktur eine elektrische Verbindung zwischen der Metallschicht (7, 37) und dem Halbleiterwafer (3, 33) bereitstellt, wobei mindestens eine erste Struktur (9a, 39a) mit einer Mindestabmessung und mindestens eine zweite Struktur (9b, 39b) mit einer Maximalabmessung als Kontaktstruktur ausgebildet werden, sodass die Mindestabmessung der ersten Struktur (9a, 39a) größer ist als die Maximalabmessung der zweiten Struktur (9b, 39b), wobei die Mindestabmessung und die Maximalabmessung entlang einer Oberfläche des Halbleiterwafers (3, 33) definiert sind, **dadurch gekennzeichnet, dass** das Ausbilden der Metallschicht (7) und der Kontaktstruktur folgende Verfahrensschritte umfasst:
- Aufbringen mindestens einer zu der dielektrischen Schicht (5) inerten Metall-Paste (13) und mindestens einer zu der dielektrischen Schicht (5) reaktiven Metall-Paste (15) auf die dielektrische Schicht (5), sodass die zu der dielektrischen Schicht (5) reaktive Metall-Paste (15) mindestens einen ersten Bereich und/oder mindestens einen zweiten Bereich in der zu der dielektrischen Schicht (5) inerten Metall-Paste (13) bildet; und
- Feuern, sodass die zu der dielektrischen Schicht (5) reaktive, den ersten und/oder zweiten Bereich bildende Metall-Paste (15) die dielektrische Schicht (5) durchdringt und die erste Struktur (9a) und/oder die zweite Struktur (9b) ausbildet.

2. Herstellungsverfahren nach Anspruch 1, **dadurch gekennzeichnet, dass** das Ausbilden der Metallschicht und der Kontaktstruktur folgende Verfahrensschritte umfasst:
- Bilden von mindestens einem ersten, zur Erzeugung der ersten Struktur geeigneten Loch und/oder mindestens einem zweiten, zur Erzeugung der zweiten Struktur geeigneten Loch in der dielektrischen Schicht;
- Auffüllen des mindestens einen ersten Lochs und/oder mindestens einen zweiten Lochs und Beschichten der dielektrischen Schicht mit einer Metall-Paste; und
- Feuern.

3. Herstellungsverfahren nach Anspruch 2, **gekennzeichnet durch** Bilden von dem mindestens einem ersten Loch und/oder dem mindestens einem zweiten Loch mittels Laserablation.

4. Herstellungsverfahren nach einem der vorhergehenden Ansprüche, **gekennzeichnet durch**
- Erzeugen der zweiten Struktur mittels LFC (laser fired contacts).

5. Herstellungsverfahren nach einem der vorhergehenden Ansprüche, **gekennzeichnet durch** Aufbringen von mindestens einem Verbinder (11) auf einer dem Halbleiterwafer abgewandten Oberfläche der Metallschicht (7) in mindestens einem Bereich, der sich mit der ersten Struktur (9a) in Draufsicht überlappt.

6. Herstellungsverfahren nach einem der vorhergehenden Ansprüche, **gekennzeichnet durch** Freilegen eines Aluminium-Silizium-Eutektikums in mindestens einer ersten Struktur (39a) und Ultraschall-Kaltverschweißen des Aluminium-Silizium-Eutektikums der ersten Struktur (39a) mit jeweils einem Verbinder (311).

## Claims

1. A solar cell manufacturing process, comprising the process steps:
- Providing a semiconductor wafer (3, 31) with at least one dielectric layer (5, 35),
- forming a metal layer (7, 37) on the dielectric layer (5, 35) and a contact structure arranged in the dielectric layer (5, 35) so that the contact structure provides an electrical connection between the metal layer (7,37) and the semiconductor wafer (3, 33), wherein at least one first structure (9a,39a) having a minimum dimension and at least one second structure (9b,39b) having a maximum dimension are formed as contact structure, so that the minimum dimension of the first structure (9a, 39a) is greater than the maximum dimension of the second structure (9b, 39b), wherein the minimum dimension and the maximum dimension are defined along a surface of the semiconductor wafer (3, 33), **characterized in that** the formation of the metal layer (7) and the contact structure comprises the following process steps:
- Applying at least one metal paste (13) inert to the dielectric layer (5) and at least one metal paste (15) reactive to the dielectric layer (5) on the dielectric layer (5) so that the metal paste (15) reactive to the dielectric layer (5) forms at least one first area and/ or at least a second area in the metal paste (13) inert to the dielectric layer (5); and
- firing so that the metal paste (15) reactive to the dielectric layer (5) and forming the first area and the second area penetrates the dielectric layer (5) and forms the first structure (9a) and / or the second structure (9b).

2. The manufacturing process according to claim 1, **characterized in that** the formation of the metal layer and the contact structure comprises the following process steps:
- forming at least one first hole suitable for the generation of the first structure and/or at least one second hole suitable for the generation of the second structure in the dielectric layer,
- filling the at least one first hole and/or the at least one second hole and coating the dielectric layer with a metal paste; and
- firing.

3. The manufacturing process according to claim 2, **characterized by** forming the at least one first hole and / or the at least one second hole by means of laser ablation.

4. The manufacturing process according to one of the preceding claims, **characterized by**
- creating the second structure using LFC (laser fired contacts).

5. The manufacturing process according to one of the preceding claims, **characterized by** applying at least one connector (11) on a surface of the metal layer (7) facing away from the semiconductor wafer in at least one area that overlaps with the first structure (9a) in plan view.

6. The manufacturing process according to one of the preceding claims, **characterized by** exposing an aluminum-silicon-eutectic in at least one first structure (39a) and ultrasonic cold welding the aluminum-silicon-eutectic of the first structure (39a) with one connector (311) each.

## Revendications

1. Un procédé de fabrication de cellules solaires, comprenant les étapes du procédé :
- Fournir une tranche de semi-conducteur (3, 31) ayant au moins une couche diélectrique (5, 35),
- former une couche métallique (7, 37) sur la couche diélectrique (5, 35) et une structure de contact qui est disposée dans la couche diélectrique (5, 35) de sorte que la structure de contact fournit une connexion électrique entre la couche métallique (7,37) et la tranche de semi-conducteur (3, 33), dans lequel au moins une première structure (9a,39a) ayant une dimension minimale et au moins une deuxième structure (9b,39b) ayant une dimension maximale sont formées comme la structure de contact, de sorte que la dimension minimale de la première structure (9a, 39a) est supérieure à la dimension maximale de la deuxième structure (9b, 39b), dans lequel la dimension minimale et la dimension maximale sont définies le long d'une surface de la tranche de semi-conducteur (3, 33), **caractérisées en ce que** la formation de la couche métallique (7) et la structure de contact comprend les étapes du procédé suivantes:
- Appliquer au moins une pâte métallique (13) inerte à la couche diélectrique (5) et au moins une pâte métallique (15) réactive à la couche diélectrique (5) sur la couche diélectrique (5) de sorte que la pâte métallique (15) réactive à la couche diélectrique (5) forme au moins une première zone et/ ou au moins une seconde zone dans la pâte métallique (13) inerte à la couche diélectrique (5) ; et
- alimenter le feu de sorte que la pâte métallique (15) réactive à la couche diélectrique (5) et formant la première zone et / ou la deuxième zone pénètre la couche diélectrique (5) et forme la première structure (9a) et / ou la deuxième structure (9b).

2. Le procédé de fabrication selon la revendication 1, **caractérisé en ce que** la formation de la couche métallique et la structure de contact comprend les étapes du procédé suivantes :
- former au moins un premier trou adapté à la génération de la première structure et/ou au moins un deuxième trou adapté à la génération de la deuxième structure dans la couche diélectrique,
- remplir le au moins un premier trou et/ou le au moins un deuxième trou et recouvrir la couche diélectrique d'une pâte de métal ;
- alimenter le feu.

3. Le procédé de fabrication selon la revendication 2, **caractérisé par** la formation du au moins un premier trou et / ou du au moins deuxième trou au moyen de l'ablation au laser.

4. Le procédé de fabrication selon l'une des revendications précédentes, **caractérisé par**
- créer la deuxième structure à l'aide de LFC (laser fired contacts).

5. Le procédé de fabrication selon l'une des revendications précédentes, **caractérisé par** appliquer au moins un connecteur (11) sur une surface de la couche métallique (7) opposée à la tranche de semi-conducteur dans au moins une zone qui chevauche la première structure (9a) en vue de plan.

6. Le procédé de fabrication selon l'une des revendications précédentes, **caractérisé par** exposer un eutectique à aluminium-silicium dans au moins une première structure (39a) et souder à froid à ultrasons l'eutectique à aluminium-silicium de la première structure (39a) avec un connecteur (311) respectivement.
